Europäisches Patentamt

European Patent Office

Office européen des brevets

(19)

(11) Veröffentlichungsnummer: **0 198 935**
**A1**

(12) # EUROPÄISCHE PATENTANMELDUNG

(21) Anmeldenummer: 85104945.2

(22) Anmeldetag: 23.04.85

(51) Int. Cl.⁴: **G 11 C 23/00**
**G 06 F 11/20**

(43) Veröffentlichungstag der Anmeldung:
29.10.86 Patentblatt 86/44

(84) Benannte Vertragsstaaten:
DE FR GB IT NL

(71) Anmelder: Deutsche ITT Industries GmbH
Hans-Bunte-Strasse 19 Postfach 840
D-7800 Freiburg(DE)

(72) Erfinder: Giebel, Burkhard, Dipl.-Ing.
Berliner Strasse 25/2
D-7809 Denzlingen(DE)

(74) Vertreter: Morstadt, Volker, Dipl.-Ing.
c/o Deutsche ITT Industries GmbH
Patent/Lizenzabteilung Postfach 840 Hans-Bunte-Strasse 19
D-7800 Freiburg/Brsg.(DE)

(54) Elektrisch umprogrammierbarer Halbleiterspeicher mit Redundanz.

(57) Das System enthält einen Mikrocomputer (µC), der in bestimmten Abständen unter Verwendung einer in einem EEPROM integrierten Klassifizierungsschaltung die Speicherzellen des EEPROMs auf Änderungen der Schwellwerte durchmißt und im Falle des Feststellens eines Fehlers in einer somit als fehlerhaft erkannten Zeile oder Spalte diese fehlerhafte Zeile bzw. Spalte, deren Adresse dann in einem Bereich (B2) gespeichert wird, durch eine redundante Zeil bzw. Spalte in einem anderen Bereich (B1) unter Verwendung eines Korrekturregisters (K) ersetzt.

EP 0 198 935 A1

**0198935**

Fl 1240 EP

Go/Be

22. April 1985

## Elektrisch umprogrammierbarer Halbleiterspeicher mit Redundanz

Die Erfindung beschäftigt sich mit elektrisch umprogrammierbaren Halbleiterspeichern, die zur Erhöhung der Gesamtausbeute redundante Zeilen oder Spalten aufweisen, welche nach Feststellung von fehlerhaften Zeilen bzw. Spalten, d.h. von Zeilen bzw. Spalten mit mindenstens einer fehlerhaften Speicherzelle, anstelle dieser Zeilen bzw. Spalten treten, soweit diese redundanten Zeilen bzw. Spalten selbst als fehlerfrei ermittelt wurden. Da im vorliegenden Fall eine Zeilenredundanz wirksamer ist als eine Spaltenredundanz, da Zeilen eher ausfallen als Spalten, wird die Erfindung im folgenden anhand der Zeilenredundanz erläutert, was aber keine Einschränkung bedeuten soll.

Zur Erläuterung des Problems der Speicherredundanz wird auf die Zeitschrift "Electronics" vom 28. 7.1981, Seiten 117 bis 133, verwiesen. Bei der praktischen Auslegung von Halbleiterspeichern mit Redundanz werden Redundanzdekoder verwendet, welche insbesondere unter Verwendung von durchtrennbaren Verbindungen programmiert werden. In diesem Zusammenhang wird beispielsweise verwiesen auf "IBM Technical Disclosure Bulletin", 18/6 (Nov. 1975) Seiten 1777 und 1778, "1980 IEEE International Solid State Circuit Conference. Digest of Technical Papers", Seiten 146 und 147 sowie die EP-A2- 83 212. Bei diesen Halbleiterspeichern mit Redundanz erfolgt die Programmierung der Redundanzdekoder, wodurch fehlerhafte Zeilen ausgeschaltet und fehlerfreie Zeilen eingeschaltet werden, bei der Abschlußmessung nach der Fertigung.

0198935

B. Giebel 7                                        Fl 1240 EP

Die Erfindung geht aus von einem integrierten Matrixspeicher nach der EP-A1- 86 905 mit m mal n nichtflüchtigen umprogrammierbaren Speicherzellen, welcher Matrixspeicher in einem ersten Teilbezirk Ersatzzeilen (redundante Zeilen) eines Ersatzspeichers aufweist, die anstelle von defekten Zeilen des Hauptspeichers über einen Ersatzdekoder (Redundanzdekoder) anwählbar sind, wobei die Adressen der defekten Zeilen in einem zweiten intakten Teilbezirk des Matrixspeichers als Daten abgelegt sind. Bei diesem bekannten Matrixspeicher sind dessen Datenausgänge mit den Dateneingängen des Korrekturregisters verbunden, welche Dateneingänge bei einem Datenübernahmesignal einer Steuerstufe zur Einleitung des Lesebetriebs und zur Übernahme der Daten aus dem zweiten Teilbezirk, die Adressen der defekten Zellen erhalten. Diese Adressen veranlassen den Ersatzdekoder, die Daten nicht in die fehlerhaften Zeilen des Hauptspeichers, sondern in zugeordnete Zeilen des Ersatzspeichers zu schreiben, wobei der Dekoder des Hauptspeichers über einen Blockierungseingang vom Ersatzdekoder ein Blockiersignal erhält.

Bei Betrieb des bekannten Matrixspeichers wird am Ende jedes Einschaltvorganges der Betriebspannung oder auch nach Abweichung der Betriebsspannung von einem Sollwert ein Normierzyklus eingeleitet, bei dem nur die Adressen des zweiten Bereichs ausgelesen und in das Korrekturregister aufgenommen werden.

An dem bekannten integrierten Matrixspeicher mit redundanten Ersatzzeilen oder auch Ersatzspalten werden, wie auch bei anderen bekannten Matrixspeichern, entsprechend den Meßergebnissen einer Abschlußmessung nach der Fertigung die Ersatzadressen der Ersatzdekoder programmiert, beispielsweise durch Manipulation eines ROMs oder auch

B. Giebel 7                                    Fl 1240 EP

durch elektrische Programmierung von Floating-Gate-Zellen, so daß in manchen Fällen eine erhebliche Ausbeutesteigerung erzielbar ist. Danach besteht aber nicht mehr die Möglichkeit, im Bedarfsfall noch im Verlaufe der Lebensdauer einer integrierten Speichermatrix Zeilen zu ermitteln, welche noch fehlerhaft geworden sind, und diese durch redundante Zeilen zu ersetzen, da der Meßaufwand einer Abschlußmessung erheblich ist.

Aufgabe der Erfindung ist daher die Angabe eines sich selbst überwachenden Systems mit einer integrierten Speichermatrix, deren Speicherzellen in bestimmten Zeitabständen zeilenweise oder auch spaltenweise auf Fehlerfreiheit überprüft werden und in der im Falle von fehlerhaft gewordenen Zeilen oder Spalten diese Zeilen bzw. Spalten durch fehlerfreie redundante Zeilen bzw. Spalten ersetzt werden.

Aus der EP-A1- 89 397 war zwar bekannt, zur Verminderung des Mehraufwandes bei der während der Abschlußmessung zu erfolgenden Klassifikation von integrierten Matrixspeichern der von der Erfindung betroffenen Art eine Vergleichsschaltung in die integrierte Speichermatrix einschließlich einer Referenzzelle, eines Referenz-Leseverstärkers und einer stufenweise von außen einstellbaren Spannungsquelle zu integrieren. Dies öffnet zwar die Möglichkeit, Messungen ohne übermäßigen Aufwand zur Ermittlung von fehlerhaften Zeilen (Spalten) an den einzelnen Speichermatrizen später nach der Verkapselung vorzunehmen, falls dafür Anschlüsse nach außen herausgeführt werden. An eine Ausnutzung dieser Möglichkeit zur regelmäßigen Überprüfung der Speichermatrix zur Ermittlung von fehlerhaft gewordenen Zeilen bzw. Spalten, welche durch redundante Zeilen bzw. Spalten ersetzt werden, ist bisher aber nicht gedacht worden, zumal auch noch zusätzlich eine Möglich

0198935

B. Giebel 7                                    Fl 1240 EP

keit bestehen müßten, entsprechend von Messungen nach der Verkapselung fehlerhafte Speicherzeilen oder Speicherspalten durch redundante zu ersetzen.

Die Erfindung geht von dem Grundgedanken aus, in den integrierten Matrixspeicher nach der EP-A1- 86 905 die Vergleichsschaltung, den Leseverstärker, den Referenz-Leseverstärker, die nichtprogrammierbare Referenzzelle und die stufenweise einstellbare Spannungsquelle mit in den Halbleiterkörper des integrierten Matrixspeichers einzubeziehen und zur laufenden Überwachung sowie zu dem im Bedarfsfalle erforderlichen Austausch einer fehlerhaften Zeile gegen eine fehlerfreie einen Mikrocomputer zu verwenden. Eine Verwendung solcher Mikrocomputer bedeutet in manchen Fällen lediglich einen zusätzlicher Aufwand an Software, nämlich bei Systemen, die bereits einen Mikrocomputer enthalten.

Die oben angegebene Aufgabe wird bei dem im Oberbegriff des Anspruchs 1 angegebenen System mit einem integrierten Matrixspeicher durch die im kennzeichnenden Teil des Anspruchs 1 angegebene Ausbildung gelöst.

Das Verfahren zum Ermitteln von defekten Zeilen in einem integrierten Matrixspeicher unter Verwendung des Systems nach der Erfindung zeichnet sich durch die im Anspruch 2 angegebenen Maßnahmen aus.

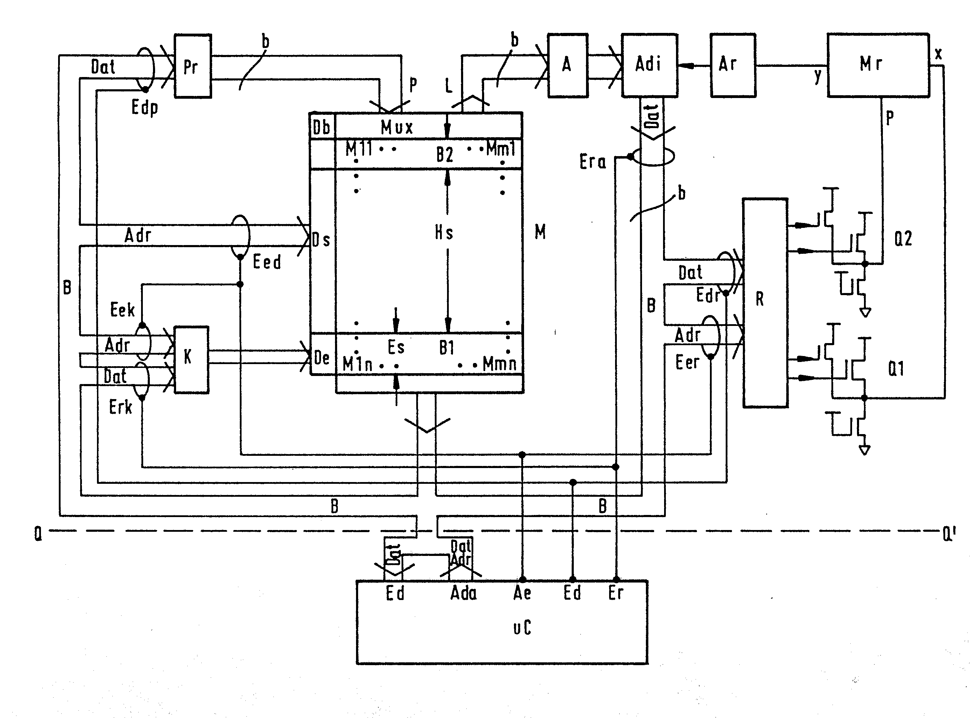

Das System und das Verfahren nach der Erfindung wird im folgenden am Blockschaltbild der Figur der Zeichnung erläutert. Dieses Blockschaltbild bezieht sich auf die Zeilenredundanz. Selbstverständlich kann die Erfindung auch an einem integrierten Matrixspeicher mit Spaltenredundanz angewendet werden.

In der Figur sind oberhalb der gestrichelten Linie Q... Q' das Blockschaltbild des monolithisch integrierten

- 5 -

B. Giebel 7                          Fl 1240 EP

Matrixspeichers und unterhalb dieser gestrichelten Linie der in dem System nach der Erfindung zu verwendente Mikrocomputer angegeben. Es liegt jedoch im Rahmen der Erfindung, das gesamte System monolithisch zu integrieren, wodurch sich monolithisch integriert ein Mikrocomputer mit einer überwachten Speichermatrix ergibt, deren Speicherzellen regelmäßig auf Fehlerfreiheit überprüft werden und wobei im Falle von fehlerhaft gewordenen Zeilen bzw. Spalten redundante Zeilen bzw. Spalten in Verwendung genommen werden.

Zentralsteuereinheit des Systems nach der Erfindung ist der Mikrocomputer µC, an dessen Dateneingang Ed und an dessen Daten/Adressen-Ausgang Ada der Bus B angeschlossen ist, über den, wie anhand der am Bus B angegebenen Pfeile veranschaulicht wird, die Daten und/oder Adressen in den Programmierschaltkreis Pr, in die Dekoderteile Ds; Db; Db, in das Korrekturregister K und in das Register R z.B. seriell gelangen können. Ferner besteht die Möglichkeit, die am Ausgang der Vergleichsschaltungen Adi auftretenden Daten, nämlich die Daten der Vergleichsmessungen der Speicherzellen mit der Referenzzelle Mr, in den Mikrocomputer uC zur logischen Aufbereitung einzuspeisen.

Der Mikrocomputer µC weist ferner den Adressenfreigabeausgang Ae auf, an dem ein Adressenfreigabesignal auftritt, das an dem Adressenfreigabeeingang Eed des Teildekoders Ds, dem Adressenfreigabeeingang Eek des Korrekturregisters K und an dem Adressenfreigabeeingang Eer des Registers R anliegt, womit dort die Adressen anwählbar sind.

Der Mikrocomputer µC weist ferner den Datenfreigabeausgang Ed auf, der mit dem Datenfreigabeeingang Edr des Registers R und mit dem Datenfreigabeeingang Edb des Programmierschaltkreises Pr verbunden ist. Bei einem dort auftretenden Datenfreigabesignal gelangen die auf dem

0198935

B. Giebel 7                                  Fl 1240 EP

Bus B vorhandenen Datensignale gleichzeitig in das Register R und in den Programmierschaltkreis Pr.

Schließlich weist der Mikrocomputer uC den Lesefreigabeausgang Er auf, der mit dem Lesefreigabeeingang Era der Vergleichsschaltung Adi und mit dem Lesefreigabeeingang Erk des Korrekturregisters K verbunden ist. Bei einem dort erscheinenden Lesefreigabesignal gelangen die Vergleichsmeßdaten der Vergleichsschaltungen Adi in den Mikrocomputer $\mu$C und werden dort ausgewertet. Soll eine defekte Zeile durch eine redundante ersetzt werden, so werden die aus der defekten Zeile in die redundante Zeile zu übertragenden Daten im Mikrocomputer vorübergehend gespeichert.

Die im ersten Teil der Figur oberhalb der gestrichelten Linie Q--- Q' ersichtliche Anordnung aus Vergleichsschaltungen Adi, Referenz-Leseverstärker Ar, Leseverstärker A, Referenzzelle Mr, Spannungsquellen Q1, Q2 und integriertem Register R entspricht derjenigen der erwähnten EP-A1- 89 397, so daß sich eine Beschreibung im einzelnen erübrigt.

Bei dem System nach der Erfindung findet ferner ein Normierzyklus statt, wie er in der EP-A1- 86 905 beschrieben wird, der beim Einschalten des Systems durch das Reset-Signal ausgelöst wird. Dabei werden die im zweiten Matrixteil B2 gespeicherten Daten in das Korrekturregister K übernommen und die fehlerhaften Zeilen des Hauptspeichers Hs der Matrix M durch Sperren der Dekoder dieser defekten Zeilen stillgelegt. Dieses Normierprogramm ist im Mikrocomputer $\mu$C gespeichert.

Das Verfahren zum Ermitteln von defekten Zeilen in dem integrierten Matrixspeicher eines Systems nach der Erfindung und das Ersetzen mindestens einer dieser Zeilen durch eine Ersatzzeile des Ersatzspeichers erfolgt nach Auslesen der im Hauptspeicher Hs gespeicherten Daten und Zwischen-

B. Giebel 7                                          Fl 1240 EP

speicherung im Mikrocomputer µC unter Verwendung der folgenden Überprüfungs-Programme, die im Mikrocomputer gespeichert sind und vom Computer in selbstbestimmten regelmäßigen Abständen oder in fremdbestimmten Abständen ausgelöst werden:

Dem Überprüfungprogrammen liegt der Gedanke zugrunde, daß
defekte Speicherzellen frühzeitig erkannt werden können,
wenn ihre Einsatzspannung in regelmäßigen Abständen überprüft wird. Die Einsatzspannung einer defekten Zelle
nähert sich nämlich im allgemeinen derjenigen des unprogrammierten Zustandes (gleich der Referenzzelle). Anfänglich ist die Änderungsrate der Einsatzspannung über der
Zeit gering, mit der Zahl der zusätzlichen Umprogrammiervorgänge nimmt sie zu, bis schließlich die Zelle nicht
mehr programmierbar erscheint. Ist die Änderungsrate noch
gering, liegt auch ein großer Zeitraum zwischen dem Erkennen einer defekten Zelle durch Lesen bei extremer Leseschwelle und dem endgültigen Ausfall, d.h. wenn die Zelle
auch bei normaler Leseschwelle nicht mehr korrekt gelesen
werden kann. Dieser Zeitraum kann zur Früherkennung von
Defekten genutzt werden, da ja die korrekten Daten noch
verfügbar sind.

Das Überprüfungsprogramm geht aus von einem mit Solldaten
beschriebenen Hauptspeicher.

Die einzelnen Speicherzeilen des Hauptspeichers Hs werden
nacheinander ausgelesen, wobei die Speicherzellen jeder
dieser Zeilen mehrmals und zwar mit jeweils anders eingestellter Referenzspannungsquelle Ar ausgelesen werden.
Dadurch werden die einzelnen Speicherzellen entsprechend
einem im Mikrocomputer µC vorhandenen Prüfprogramm wortweise einer Überprüfung ihres Schwellwertes Ur unterworfen.

0198935

B. Giebel 7                                    Fl 1240 EP

Der Mikrocomputer stellt nun anhand der Abweichungen entsprechend einem ersten Programm die Abweichung der Leseergebnisse mit extrem eingestellter Referenzspannungsquelle
zum Leseergebnis mit normal eingestellter Referenzspannungsquelle fest, ob eine Zeile defekt ist. In diesem
Falle des Erkennens einer defekten Speicherzelle veranlaßt
der Mikrocomputer entsprechend einem zweiten Programm den
Ersatz der defekten Zeile durch eine verfügbare Ersatzzeile im Ersatzspeicher Es. Zu diesem Zwecke sind die
Daten aller Speicherzellen der defekten Zeile bei normaler
Referenzspannung im Mikrocomputer zu speichern und die
Adresse der defekten Zeile vom Mikrocomputer in den zweiten Matrixteil B2 einzuprogrammieren. Dann wird die Adresse der defekten Zeile durch Auslesen des zweiten Matrixteils B2 durch den Mikrocomputer an den Eingang des Korrekturregisters K angelegt und dort gespeichert. Schließlich
werden die im Mikrocomputer gespeicherten Daten der defekten Zeile vom Mikrocomputer gesteuert in die Ersatzzeile
einprogrammiert.

Durch die Erfindung läßt sich nicht nur die Ausbeute an
brauchbaren integrierten Speichermatrizen steigern, sondern auch noch deren Lebensdauer. Die Zuverlässigkeit der
zu speichernden Daten ist so lange gesichert, wie noch
redundante Zeilen frei sind.

Im übrigen ist, abgesehen von den geschilderten Programm-
men, im Mikrocomputer noch das in der genannten EP-A1-
86 905 erwähnte Normierungsprogramm gespeichert, bei dem
am Ende jedes Einschaltvorganges oder nach einer Abweichung der Betriebsspannung von einem Sollwert ein Normierzyklus der Matrix eingeleitet wird, bei dem die Matrix nur
mit den Adressen des zweiten Teilbereichs B2 gespeist wird
und die Adressen der defekten Zeilen in das Korrekturregister eingelesen werden.

- 9 -

01.98935

B. Giebel 7

Fl 1240 EP
Go/Be
22.April 1985

Patentansprüche

1. System mit einem integrierten Matrixspeicher, dessen m mal n Speicherzellen je ein elektrisch schwebendes Zwischengate (floating gate) aufweisen, welcher Matrixspeicher

- in einem ersten Teilbereich (B1) Ersatzzeilen eines Ersatzspeichers und in einem zweiten Teilbezirk (B2) Speicherzellen enthält, in denen als Daten die Adressen von fehlerhaften Zeilen eines Hauptspeichers (Hs) einprogrammierbar sind, welcher in einem dritten Teilbezirk des Matrixspeichers angeordnet ist, wobei

- die Ersatzzeilen für defekte Zeilen des Hauptspeichers über einen Ersatzdekoder (De) unter Blockierung der fehlerhaften Zeilen anwählbar sind, der von einem Korrekturregister (K) ansteuerbar ist, das als Daten die Adressen mindestens einer fehlerhaften Zeile des Hauptspeichers enthalten kann, die in das Korrekturregister (K) übernommen werden, wenn über den Adreßeingang (Ea) die Adressen des zweiten Teilbezirks (B2) angelegt waren und sodann die Daten des zweiten Teilbezirks (B2) ausgelesen wurden und wobei

- die Speichermatrix in ein System mit einem Mikroprozessor einbezogen ist,

dadurch gekennzeichnet,

- daß das Korrekturregister (K) zur Durchschaltung von Adressen an den Ersatzdekoder (De) oder deren Sperrung ausgelegt ist und die Spalten der Matrix über einen Multiplexer (Mux) ihre Daten seriell erhalten,

- daß der integrierte Matrixspeicher entsprechend der Stellenzahl eines Speicherwortes b Vergleichsschaltungen (Adi) enthält, an deren ersten Eingängen von den Drain-Strömen der Speichertransistoren des angewählten Wortes abgeleitete erste Spannungssignale und an deren zweiten Eingängen die Spannung einer Referenzspannungsquelle (Ar) liegen,

- daß die Ausgänge der Vergleichsschaltungen (Adi) an einem Daten/Adress-Bus (B) liegen, der mit dem Dateneingang (Ed) und einem Daten/Adress-Ausgang (Ada) eines den Mikroprozessor enthaltenden Mikrocomputers (µC) verbunden ist,

- daß der Mikrocomputer (µC) einen Adressenfreigabeausgang (Ae) aufweist, mit dem der Adressenfreigabeeingang (Eed) des Dekoders (Ds) des Hauptspeichers (Hs), der Adressenfreigabeeingang (Eer) eines Registers (R), über das stufenweise die Referenzspannungsquelle (Ar) einstellbar ist, und der Adressenfreigabeeingang (Eek) des Korrekturregisters (K) verbunden ist,

- daß der Mikrocomputer (µC) ferner einen Datenfreigabeausgang (Ed) aufweist, der mit einem Datenfreigabeeingang (Edr) des Registers (R) und mit dem Datenfreigabeeingang (Edp) eines Programmierschaltkreises (Pr) verbunden ist, der befähigt ist, die Speicherzellen eines Wortes des Hauptspeichers (Hs) entsprechend von über den Bus (B) an den Eingang des Programmierschaltkreises (Pr) gelangenden Daten zu programmieren,

- daß der Mikrocomputer (µC) einen Lesefreigabeausgang (Er) aufweist, der mit dem Lesefreigabeeingang (Era) der Vergleichsschaltungen (Adi) und mit dem Lesefreigabeeingang (Erk) des Korrekturregisters (K) verbunden ist, und

- daß der Bus (B) geeignet ist, parallel und/oder sequentiel die Ausgangssignale der Vergleichsschaltungen (Adi) dem Mikrocomputer (µC) zu vermitteln und parallel und/oder sequentiel sowohl Adressensignale als auch Datensignale vom Mikrocomputer (µC) in das Register (R), in das Korrekturregister (K), in den Programmierschaltkreis (Pr) zu übertragen.

B. Giebel 7                                    Fl 1240 EP

2. Verfahren zum Ermitteln von defekten Zeilen eines integrierten Matrixspeichers nach Anspruch 1, und Ersetzen mindestens einer dieser Zeilen durch eine Ersatzzeile des Ersatzspeichers (Es), dessen Ersatzzeilen für defekte Zeilen des Hauptspeichers (Hs) über einen Ersatzdekoder (De) angewählt werden, wobei

- die Adresse(n) der defekten Zeile(n) als Daten in einen zweiten Teilbezirk (B2) der Speichermatrix (M) einprogrammiert werden und

- die Adresse(n) der defekten Zeile(n) als Daten in das Korrekturregister (K) übernommen werden, wenn über den Adreßeingang die Adressen des zweiten Teilbezirks (B2) angelegt waren, und sodann die Daten des zweiten Teilbezirks (B2) ausgelesen werden,

dadurch gekennzeichnet,

- daß von einem den Mikroprozessor enthaltenden Microcomputer (µC) in selbstbestimmten oder fremdbestimmten Abständen Adreß- und Datensignale dergestalt erzeugt werden,

- - daß die einzelnen Speicherzeilen des Hauptspeichers (Hs) nacheinander ausgelesen werden, wobei die Speicherzellen jeder dieser Zeilen mehrmals, und zwar mit jeweils anders eingestellter Referenzspannungsquelle (Ar) ausgelesen werden, wodurch die einzelnen Speicherzellen programmgemäß im Microcomputer (µC) wortweise einer Überprüfung des Schwellwertes (Ur) unterworfen werden, und

- - daß entsprechend einem ersten Programm nach Feststellung einer Abweichung eines Leseergebnisses mit extrem eingestellter Referenzspannungsquelle (Ar) zum Leseergebnis mit normal eingestellter Referenzspannungsquelle der Microcomputer (µC) Veranlassung trifft, entsprechend einem zweiten Programm die defekte Zeile mit mindestens einer somit als geschwächt erkannten Speicherzelle durch

B. Giebel 7                                              Fl 1240 EP

eine verfügbare Ersatzzeile im Ersatzspeicher (Es) zu ersetzen, indem zunächst das Leseergebnis aller Speicherzellen der defekten Zeile bei normaler Referenzspannung im Microcomputer gespeichert wird, dann die Adresse der defekten Zeile vom Microcomputer in den zweiten Matrixteil (B2) einprogrammiert wird, die Adresse der defekten Zeile durch Auslesen des zweiten Matrixteils (B2) durch den Microcomputer an den Eingang des Korrekturregisters (K) angelegt und darin gespeichert wird und schließlich die im Microcomputer gespeicherten Daten der defekten Zeile vom Microcomputer gesteuert, in die Ersatzzeile einprogrammiert werden.

85 10 4945.2

0198935

**Europäisches Patentamt**

## EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
|---|---|---|---|
| Y | DE-A-3 317 160 (NATIONAL SEMICONDUCTOR) * Seite 14, Zeilen 6-22; Seite 15, Zeilen 1-16; Seite 17, Zeilen 14-26; Seite 18, Zeilen 5-27; Seite 19, Zeilen 1-6; Figuren 1,2 * | 1,2 | G 11 C 29/00 G 06 F 11/20 |
| | --- | | |
| Y | DE-A-3 134 995 (BOSCH) * Seite 6, Zeilen 6-13; Seite 8, Zeilen 16-20,32-34; Seite 9, Zeilen 2-9,33-35; Seite 10, Zeilen 1-4,24-27; Figur 1 * | 1,2 | |
| | --- | | |
| Y | PATENTS ABSTRACTS OF JAPAN, Band 7, Nr. 87 (P-190)[1232], 12 April 1983; & JP - A - 58 14398 (HITACHI SEISAKUSHO K.K.) 27.01.1983 * Insgesamt * | 1,2 | |
| | | | RECHERCHIERTE SACHGEBIETE (Int Cl.4) |
| | --- | | |
| A,D | EP-A-0 086 905 (DEUTSCHE ITT) * Seite 1, Zeilen 1-12; Seite 3, Zeilen 8-31; Figur * | 1,2 | G 11 C 29/00 G 06 F 11/20 G 11 C 11/34 |
| | --- | | |
| A,D | EP-A-0 089 397 (DEUTSCHE ITT) * Seite 2, Zeilen 10-33; Seite 4, Zeilen 6-36; Seiten 5-7; Seite 8, Zeilen 1-7; Figur 2 * | 1,2 | |
| | ----- | | |

Der vorliegende Recherchenbericht wurde für alle Patentansprüche erstellt.

| Recherchenort DEN HAAG | Abschlußdatum der Recherche 16-12-1985 | Prüfer DHEERE R.F.B.M. |
|---|---|---|